# EUROPEAN PATENT APPLICATION

(11) **EP 3 178 964 A1**
(43) Date of publication of application: **14.06.2017**
(21) Application number: 16202816.1
(22) Date of filing: 08.12.2016
(51) Int. Cl.: C23C 16/24, C23C 16/44

(54) **CVD APPARATUS**

(30) Priority: 09.12.2015 KR 20150175228
(71) Applicant: OCI Company Ltd., Seoul 100-718 (KR)
(72) Inventor: OH, Min-Kyung, 13212 Gyeonggi-do (KR); KANG, Byung-Chang, 13212 Gyeonggi-do (KR); YOON, Jong-Soo, 13212 Gyeonggi-do (KR); YOON, Min-Young, 13212 Gyeonggi-do (KR)
(74) Representative: Awapatent AB

(57) **Abstract**

The present disclosure relates to a polysilicon preparation apparatus for preventing ground fault current and having an excellent effect of removing silicon dust. The polysilicon preparation apparatus includes a chamber comprising a housing with an opened lower portion and a base plate coupled to the lower portion of the housing, and a ceramic particle layer on an upper surface of the base plate, for preventing silicon dusts generated during a process from directly contacting the base plate and to be removed together with silicon dusts after the process.

## Description

### BACKGROUND

### 1. Technical Field

The present disclosure relates to a polysilicon preparation apparatus, and more particularly, to a polysilicon preparation apparatus, for facilitating cleaning of silicon dusts formed on an internal wall of a base plate during preparation of polysilicon according to Siemens reaction and for preventing ground fault current.

In addition, the present disclosure relates a method of making it easier to remove silicon dusts from a base plate.

### 2. Description of the Related Art

A CVD(Chemical Vapor Deposition) chamber used to prepare polysilicon is mainly formed of nickel or stainless steel.

Thereamong, the stainless steel chamber is disadvantageous in that corrosion resistance of reaction gas of a polysilicon precursor is poor.

The nickel chamber is advantageous in terms of excellent corrosion resistance to reaction gas but is disadvantageous in that it is difficult to remove silicon dusts formed during a CVD process. This is because nickel reacts with silicon dusts to form nickel silicide (NiSix). Nickel silicide (NiSix) has high coherence with silicon dusts and, thus, it is difficult to remove silicon dusts form the chamber.

Since silicon dusts contains a plurality of metal impurities, silicon dusts drop off purity of polysilicon and also generates ground fault current between a base plate and a silicon rod, thus, it is necessary to clean silicon dusts during a cleansing process.

In the case of a bell jar, which is a upper part of the CVD chamber, it is possible to move and clean the bell jar by using a machine. However, in the case of a base plate, it is difficult to move the base plate from a ground, thus, the base plate needs to be cleaned in a place in which the base plate is installed.

A method of cleaning a base plate includes a method of wiping the base plate using an aqueous solution of NaOH and a wiper by operators and a grinding method using sandpaper.

In the case of the method using an aqueous solution of NaOH and a wiper, operators are in danger from a contamination of NaOH, which is a strong alkali solution.

In the case of the grinding method, a great amount of dusts is generated during a cleaning process. The possibility that the generated dusts are spread in a clean room is very high and the dust may affect other chambers and respiratory organs of an operator. In addition, a nickel layer is damaged by physical force that is applied during a dry grinding process and, thus, a lifetime of a base plate may be reduced.

As the prior art related to the present disclosure, Korean Patent Publication No. 10-2012-0093486 (published on August 23, 2012) discloses a polysilicon preparation apparatus with increased dust recovery function and cleaning convenience.

The above document discloses a dust recoverer on a chamber but does not disclose an element for removing silicon dusts accumulated on a base plate at a lower portion of the chamber.

### SUMMARY

It is an object of the present disclosure to provide a silicon preparation apparatus that prevents ground fault current from being generated on a base plate during a polysilicon preparation process and has an excellent effect of removing silicon dusts from the base plate.

It is another object of the present disclosure to provide a method of removing silicon dusts after a polysilicon preparation process.

Objects of the present disclosure are not limited to the above-described objects and other objects and advantages can be appreciated by those skilled in the art from the following descriptions. Further, it will be easily appreciated that the objects and advantages of the present disclosure can be practiced by means recited in the appended claims and a combination thereof.

In accordance with one aspect of the present disclosure, a polysilicon preparation apparatus includes a chamber comprising a housing with an opened lower portion and a base plate coupled to the lower portion of the housing, and a ceramic particle layer on an upper surface of the base plate, for preventing silicon dusts generated during a process from directly contacting the base plate and to be removed together with silicon dusts after the process.

As described above, according to the present disclosure, the ceramic particle layer may be formed on the base plate. By virtue of presence of the ceramic particle layer, silicon dusts generated during a process may be prevented from directly contacting the base plate. Accordingly, metallic silicide may be prevented from being generated. This is because metallic silicide is generated via reaction between silicon components of silicon dusts and metallic components included in the base plate and, according to the present disclosure, the ceramic particle layer prevents this reaction.

The ceramic particle layer is in a particle state and, thus, is advantageously cleaned by water.

In this case, the base plate may have a surface formed of a nickel material.

The base plate may be formed of a nickel material or formed of stainless steel coated with nickel. Nickel is advantageous in terms of excellent corrosion resistance to silane gas as a polysilicon precursor at a high temperature.

The ceramic particle layer may include ceramic with a particle diameter of 5 to 300 nm. Within the above range of the particle diameter of ceramic, ceramic particles may be uniformly coated on the base plate using a spraying method.

The ceramic particle layer may have a thickness of 10 to 200 µm.

Within the thickness of the ceramic particle layer, metallic silicide may be sufficiently prevented from being formed and may be easily removed during cleaning.

The ceramic particle layer may have a heat-resistant (sintering) temperature of 600 °C or more and include insulating ceramic.

The ceramic particle layer needs to be easily removed while being cleaned and, thus, may be prevented from being fixed to the base plate during preparation of polysilicon using insulating ceramic with a high heat-resistance temperature.

The ceramic particle layer may include one or more of aluminum oxide, aluminum nitride, silicon oxide, and silicon nitride.

Ceramic materials have a high heat-resistance temperature and insulation properties and, thus, may be appropriately used in a ceramic particle layer.

In accordance with another aspect of the present disclosure, a method of removing dust from a base plate, the method including coating and drying a coating solution containing a ceramic particle on an upper surface of the base plate, and performing cleaning after a polysilicon preparation process using a preparation apparatus comprising the base plate to remove a particle layer formed of the ceramic particle and silicon dusts accumulated on the particle layer..

According to the present disclosure, silicon dusts accumulated on a ceramic particle during cleaning may be effectively removed using the ceramic particle layer as a sacrificial layer.

In this case, the coating may be performed using a spraying method. Among various coating methods, the spraying method is a method of easily and uniformly coating ceramic particles on a large area for a short time.

The cleaning may be performed via water cleaning. As a result of experimentation, it may be seen that a ceramic particle layer and silicon dusts accumulated thereon may be clearly removed via only water cleaning.

### BRIEF DESCRIPTION OF DRAWINGS

FIG. 1 is a schematic diagram of a polysilicon preparation apparatus applicable to the present disclosure.
FIG. 2 is a diagram illustrating a conventional cleaning process of silicon dusts from a base plate.
FIG. 3 is a schematic diagram of a base plate including a ceramic particle layer formed thereon according to an exemplary embodiment of the present disclosure.
FIG. 4 is a diagram illustrating a procedure of cleaning silicon dusts from a base plate on which a ceramic particle layer is formed, according to the present disclosure.
FIG. 5a and FIG 5b, are a diagram illustrating a state of a surface of a conventional base plate and a state of a surface of a base plate including a ceramic particle layer formed thereon according to the present disclosure after cleaning.
FIG. 6a and FIG. 6b, are a diagram illustrating states before and after cleaning when a ceramic particle layer is and is not formed on a quartz ring.

### DETAILED DESCRIPTION

The above objects, features and advantages will become apparent from the detailed description with reference to the accompanying drawings. Embodiments are described in sufficient detail to enable those skilled in the art in the art to easily practice the technical idea of the present disclosure. Detailed descriptions of well known functions or configurations may be omitted in order not to unnecessarily obscure the gist of the present disclosure. Hereinafter, embodiments of the present disclosure will be described in detail with reference to the accompanying drawings. Throughout the drawings, like reference numerals refer to like elements.

Hereinafter, a polysilicon preparation apparatus that prevents ground fault current from being generated and has an excellent effect of removing silicon dusts will be described in detail.

Polysilicon refers to high-purity polycrystalline silicon used as a material of a solar battery or a semiconductor.

Polysilicon is prepared by a polysilicon preparation apparatus that is generally called a Siemens reactor.

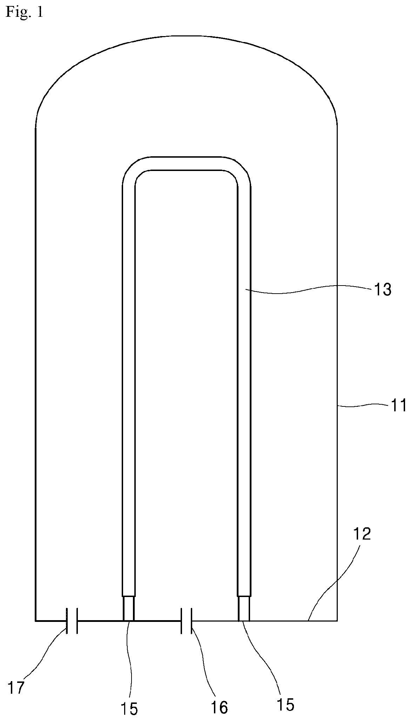

FIG. 1 is a schematic diagram of a polysilicon preparation apparatus applicable to the present disclosure.

Referring to FIG. 1, a general polysilicon preparation apparatus may include a housing 11, a base plate 12, a silicon rod 13, electrodes 15, a reaction gas supplier 16, and an exhaust port 17.

The housing 11 may have an opened lower portion, the base plate 12 may be coupled to the lower portion of the housing 11, and the silicon rod 13 with an inverted U shape is disposed on the base plate 12. The electrodes 15 may be connected to opposite ends of the silicon rod 13 so as to electric-resistance heat the silicon rod 13 and may be formed through the base plate 12. In this case, the electrodes 15 may be insulated from the base plate 12.

The base plate 12 may have a surface formed of a ceramic material such as nickel, stainless steel, and quartz. In detail, the base plate 12 may be formed of a nickel material or formed of stainless steel coated with nickel. Nickel is advantageous in terms of excellent corrosion resistance to silane gas as a polysilicon precursor at a high temperature and excellent thermal durability as compared with stainless steel.

As silicon precursor gas for preparing polysilicon, dichlorosilane, trichlorosilane, tetrachlorosilane, monosilane, or the like has been used and trichlorosilane has been widely used according to economic considerations.

When the silicon precursor gas is injected into a reactor including the housing 11 and the base plate 12 through the reaction gas supplier 16, polysilicon is precipitated while the silicon precursor gas undergoes hydrogen reductive reaction and is thermally decomposed by the silicon rod 13 that is connected to the electrodes 15 and electric-resistance heated. Residual gas is discharged through the exhaust port 17.

Silicon dusts in a solid state is generated in a polysilicon preparation apparatus during a polysilicon preparation process and accumulates on an internal wall of the housing 11 and the base plate 12. Silicon dusts hinders measurement of temperature in a bell type reactor, makes a surface of a silicon core rode uneven, adversely affecting the quality of prepared polysilicon, and a process yield is also degraded and, thus, it may be necessary to remove silicon dust.

In particular, in the case of the base plate 12 having a surface formed of a nickel material, nickel silicide is formed on the surface of the base plate 12 while silicon dusts accumulates. In this regard, nickel silicide has strong adhesion and, thus, it may be difficult to easily remove adhered silicon dust. Nickel silicide has electrical conductivity and ground fault current whereby the electrodes 15 and the base plate 12 are electrically connected may be generated due to nickel silicide. Accordingly, there is a need for an element for effectively removing silicon dusts and preventing ground fault current from being generated.

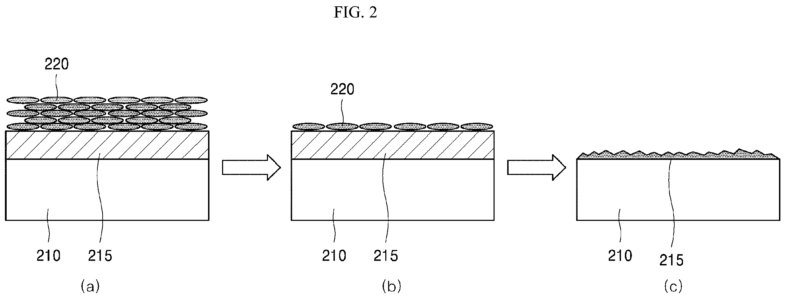

FIG. 2 is a diagram illustrating a conventional cleaning process of silicon dusts from a base plate.

Referring to FIG. 2(a), conventionally, silicon dusts 220 accumulates on a base plate 210 formed of a nickel material and silicon components of silicon dusts and nickel are generated to form nickel silicide 215 during a polysilicon preparation process.

Referring to FIG. 2(b), most of the silicon dusts 220 is removed via a dust suction process but a portion that contacts the nickel silicide 215 is not easily removed. Nickel silicide has strong adhesion and, thus, silicon dusts that contacts nickel silicide is not easily removed.

In order to remove silicon dusts that contacts nickel silicide, silicon dusts that contacts nickel silicide may be removed via grinding using a buffing device as illustrated in FIG. 2(c).

Conventionally, there is problem in that an additional process is required in order to remove nickel silicide and nickel silicide is not completely removed or surface roughness of a base plate is increased after a grinding process, as illustrated in FIG. 2(c).

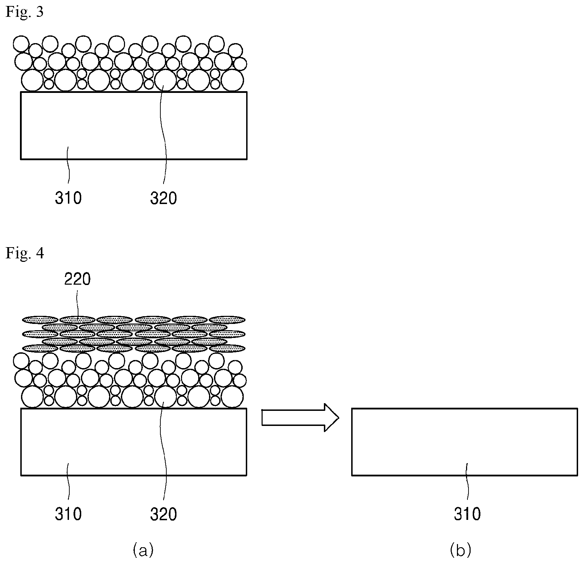

According to the present disclosure, in order to overcome this problem, as illustrated in FIG. 3, a ceramic particle layer 320 may be disposed on an upper surface of a base plate 310. Here, the ceramic particle layer 320 refers to a layer for maintaining an original state in which ceramic powders are coated and corresponds to a state in which sintering is not performed.

Since the ceramic particle layer 320 is formed on the upper surface of the base plate 310, silicon dusts generated during preparation of polysilicon may be prevented from directly contacting the base plate 310, thereby preventing metallic silicide from being generated. This is because metallic silicide is generated via reaction between silicon components of silicon dusts and metallic components (e.g., nickel) included in the base plate and, according to the present disclosure, the ceramic particle layer 320 prevents this reaction.

The ceramic particle layer 320 is in a particle state and, thus, is advantageously cleaned by water.

The ceramic particle layer 320 may include ceramic with a particle diameter of 5 to 300 nm. Within the above range of the particle diameter of ceramic, ceramic particles may be uniformly coated on the base plate using a spraying method. When the particle diameter of the ceramic particles is less than 5 nm, the ceramic particle is fixed to the base plate and, thus, it may be difficult to easily remove the ceramic particles, and when the particle diameter of the ceramic particles is greater than 300 nm, it may be difficult to uniformly coat ceramic particles on the base plate using a spraying method.

The ceramic particle layer 320 may have a thickness of 10 to 200 µm. Within this thickness of the ceramic particle layer 320, metallic silicide may be sufficiently prevented from being formed and may be easily removed during cleaning. Air voids are present between ceramics in a particle state and, thus, when the thickness of the ceramic particle layer is less than 10 *µ*m, the possibility that silicon dusts contacts the base plate 310 is increased and, thus, the thickness of the ceramic particle layer may be equal to or greater than 10 µm. On the other hand, even if the thickness of the ceramic particle layer 320 is greater than 200 µm, further effects may not occur.

The ceramic particle layer 320 may have a heat-resistant (sintering) temperature of 600 °C or more and include insulating ceramic. The ceramic particle layer 320 needs to be easily removed while being cleaned and, thus, may be prevented from being fixed to the base plate 310 during preparation of polysilicon using insulating ceramic with a high heat-resistance temperature. In addition, the ceramic particle layer 320 needs to have insulating properties in order to maintain an insulation state between the electrodes 15 (see FIG. 1) and the base plate 310.

The ceramic particle layer 320 may include one or more of aluminum oxide, aluminum nitride, silicon oxide, and silicon nitride and, in detail, aluminum oxide may be proposed. Ceramic materials have a high heat-resistance temperature and insulation properties and, thus, may be appropriately used in a ceramic particle layer.

FIG. 4 is a diagram illustrating a procedure of cleaning the silicon dusts 220 on the base plate 310 on which the ceramic particle layer 320 is formed, according to the present disclosure.

Referring to FIG. 4(a), the silicon dusts 220 may accumulate on the ceramic particle layer 320 disposed on the base plate 310 formed of a nickel material and may not directly contact nickel of the base plate 310.

Accordingly, the conventional nickel silicide 215 (refer to FIG. 3) may be prevented from being formed. In addition, the ceramic particle layer 320 is in a particle or powder state and is not completely fixed to the base plate 310 and, thus, the ceramic particle layer 320 may be easily removed using only water. Accordingly, as illustrated in FIG. 4(b), the silicon dusts 220 together with the ceramic particle layer 320 may be easily removed via water cleaning using a loofah, a wiper, or the like. In addition, the silicon dusts 220 may be effectively removed via only water cleaning, thereby reducing dust in a clean room and extending a lifetime of a base plate.

The ceramic particle layer 320 may be easily formed using a spraying method. For example, a procedure of spraying a coating solution prepared by dispersing ceramic powder such as alumina powder in a volatile solvent such as acetone in about 0.5 to 30 wt% using a spraying method and drying the resultant may be repeated once or twice to form a ceramic particle layer with a desired thickness. Prior to the spraying method, a procedure of cleaning a surface of a base plate with alcohol or the like may be further performed.

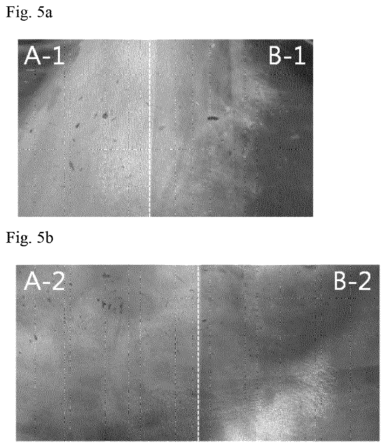

FIG. 5a and FIG. 5b are a diagram illustrating a state of a surface of a conventional base plate and a state of a surface of a base plate including a ceramic particle layer formed thereon according to the present disclosure after cleaning.

In FIG. 5a and FIG. 5b., the ceramic particle layer is formed of alumina powder with a particle diameter of 5 to 300 nm and is formed to a thickness of 100 µm on a nickel base plate, and a procedure of preparing polysilicon is performed prior to cleaning.

In FIG. 5a, A-1 and A-2 show a surface state after a test piece including a ceramic particle layer is cleaned.

In FIG. 5b, B-1 and B-2 show a surface state after a test piece without a ceramic particle layer is cleaned.

As seen from A-1 of FIG. 5a, silicon dusts is clearly removed only via general water cleaning. On the other hand, as seen from B-1 of FIG. 5(a), some silicon dusts remains.

In addition, as seen from A-2 and B-2 of FIG. 5b, in the case of B-2 in which grinding with a buffing device is performed and then water cleaning is performed, stains are present on a surface due to non-removed nickel-silicide and the surface is seriously scratched as compared with A-2 in which only water cleaning is performed.

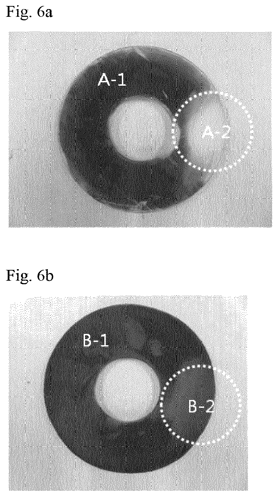

FIG. 6a and FIG. 6b are a diagram illustrating states before and after cleaning when a ceramic particle layer is and is not formed on a quartz ring.

In FIG. 6a and FIG. 6b, a polysilicon preparation process is performed using a quartz ring as a base plate in the same way as the aforementioned method and water cleaning is performed.

As seen from FIG. 6a, in the case of a test piece A-1 including a ceramic particle layer, silicon dusts is clearly removed from a cleaned portion A-2 simply by performing water cleaning with a wiper soaked in water. However, as seen from FIG. 6b, in the case of a test piece B-1 without a ceramic particle layer, even if cleaning is performed in the same way as in FIG. 6a, silicon dusts of a cleaned portion B-2 is not completely removed and some dust remains.

As described above, it may be seen that the surface of the base plate on which the polysilicon preparation process is performed and then cleaning is completely performed has an obvious difference between a region including an alumina particle layer and a region without an alumina particle layer.

A surface portion on which an alumina particle layer is formed is cleaned using only a loofah, a wiper, and water, grinding is performed on a non-coated surface portion and, then, the resulting structure is wiped by a wipe and water to complete the process. When the alumina particle layer is used, a cleaning time is halved or less as compared with the conventional case and dust is barely generated. In addition, a surface of a nickel base plate is observed not to be absolutely damaged and to have similar brilliance to the case prior to the polysilicon preparation process.

On the other hand, in the case of a test piece without an alumina particle layer, it is seen that, even if cleaning is completed, nickel silicide is not completely removed, a surface of the test piece is stained, and the brilliance of the surface is recued due to surface damage during a grinding process using a buffing device.

As seen from the result illustrated in FIG. 6a and FIG. 6b, a cleaning effect is also enhanced when a base plate is not formed of a metallic material and, thus, the ceramic particle layer according to the present disclosure may be applied to stainless steel, ceramic, or the like as well as a base plate with a nickel surface.

When the aforementioned case in which a ceramic particle layer according to the present disclosure is applied, the following advantages may be achieved.

First, a cleaning method of silicon dusts of a base plate formed of nickel may be enhanced. As compared with a conventional method, the number of operators and a time for cleaning may be reduced and a cost of sandpaper, a cost of a machine, and so on, required for using a buffing device, may be reduced. In addition, dust generated due to use of the buffing device may be remarkably reduced and, thus, the quality of polysilicon may be improved and an operating environment of an operator may also be improved.

Second, production efficiency of polysilicon may be enhanced by preventing ground fault current. Ceramic such as alumina has very high insulation resistance. Accordingly, flow of ground fault current to be generated on a surface of a base plate may be shut off so as to prevent ground fault. This may enhance production efficiency of polysilicon in a current condition and may strictly adjust a condition of subsequent processes so as to maximize production efficiency.

Third, a lifetime of a reactor may be increased. For example, a nickel base plate is in a state in which a parent material of stainless steel is clad in nickel. However, nickel is also grinded during grinding of silicon dusts and a nickel silicide layer using a grinder and, thus, the nickel layer may be damaged and a surface thereof may be roughened. However, the ceramic particle layer may be formed and, thus, the grinding process may be omitted, thereby increasing a lifetime of a polysilicon deposition apparatus.

In the case of a polysilicon preparation apparatus according to the present disclosure, a ceramic particle layer is formed on a base plate. Thereby, the base plate may be prevented from directly contacting silicon dusts so as to prevent metallic silicide from being formed and, thus, even if silicon dusts accumulates on the base plate, electrical connection between the silicon rod and the base plate may be prevented, thereby preventing ground fault current from being generated.

In addition, a ceramic particle layer may be easily removed via only water cleaning and, thus, an effect of removing silicon dusts may be advantageously excellent.

The present disclosure described above may be variously substituted, altered, and modified by those skilled in the art to which the present disclosure pertains without departing from the scope and sprit of the present disclosure. Therefore, the present disclosure is not limited to the above-mentioned exemplary embodiments and the accompanying drawings.

## Claims

1. A polysilicon preparation apparatus comprising:
a chamber comprising a housing with an opened lower portion and a base plate coupled to the lower portion of the housing; and
a ceramic particle layer on an upper surface of the base plate, for preventing silicon dusts generated during a process from contacting directly the base plate and to be removed together with silicon dusts after the process.

2. The polysilicon preparation apparatus according to claim 1, wherein the base plate has a surface formed of a nickel material.

3. The polysilicon preparation apparatus according to claim 1, wherein the ceramic particle layer comprises ceramic with a particle diameter of 5 to 300 nm.

4. The polysilicon preparation apparatus according to claim 1, wherein the ceramic particle layer has a thickness of 10 to 200 µm.

5. The polysilicon preparation apparatus according to claim 1, wherein the ceramic particle layer has a heat-resistance temperature of 600 °C or more and comprises insulating ceramic.

6. The polysilicon preparation apparatus according to claim 1, wherein the ceramic particle layer comprises one or more of aluminum oxide, aluminum nitride, silicon oxide, and silicon nitride.

7. A method of removing dust from a base plate, the method comprising:
coating and drying a coating solution containing a ceramic particle on an upper surface of the base plate; and
performing cleaning after a polysilicon preparation process using a preparation apparatus comprising the base plate to remove a particle layer formed of the ceramic particle and silicon dusts accumulated on the particle layer.

8. The method according to claim 7, wherein the coating is performed using a spraying method.

9. The method according to claim 7, wherein the cleaning is performed via water cleaning.
